# FASCICULE DE BREVET EUROPEEN

(11) **EP 0 642 176 B1**
(45) Date de publication et mention de la délivrance du brevet: **26.05.1999**
(21) Numéro de dépôt: 94410073.4
(22) Date de dépôt: 05.09.1994
(51) Int. Cl.: H01L 29/87

(54) **Diode de shockley bidirectionnelle**
Bidirektionale Schockleydiode
Bidirectional schockley diode

(30) Priorité: 07.09.1993 FR 9310883
(43) Date de publication de la demande: 08.03.1995
(73) Titulaire: STMicroelectronics S.A., 94250 Gentilly (FR)
(72) Inventeur: Salbreux, Jean-Claude, F-37540 Saint Cyr Sur Loire (FR)
(74) Mandataire: de Beaumont, Michel

(56) Documents cités:
- EP-A- 0 537 843
- US-A- 3 476 993
- US-A- 4 868 703
- PATENT ABSTRACTS OF JAPAN vol. 2, no. 156 (E-81) 26 Décembre 1978 & JP-A-53 124 987 (MITSUBISHI DENKI K.K.) 31 Octobre 1978

## Description

La présente invention concerne les composants de protection et plus particulièrement les composants de protection bidirectionnels, c'est-à-dire capable d'absorber aussi bien une surcharge négative qu'une surcharge positive, du type diode de Shockley bidirectionnelle ou triac sans gâchette.

Un tel composant présente dans chacune des polarités une même tension de claquage VBO et, quand la tension à ses bornes dépasse cette tension de claquage, il entre en conduction et présente à ses bornes une chute de tension très faible. Il reste ensuite conducteur tant que le courant qui le traverse reste supérieur à une valeur de maintien IH. Ceci est par exemple décrit dans JP-A-53 124 987 où l'on trouve en outre un recouvrement, non quantifié, entre les couches extrêmes des faces supérieure et inférieure dans le but d'améliorer les caractéristiques de déclenchement.

Une autre caractéristique importante de ce composant est la puissance ou le courant maximum IPP qu'il peut supporter pendant une surcharge. Il est connu que ce courant est lié à la surface du composant.

Un objet de la présente invention est de permettre un accroissement du courant maximum IPP supportable par une diode de Shockley bidirectionnelle pour une surface donnée de cette diode de Shockley.

Pour atteindre cet objet, la présente invention prévoit un composant de protection du type diode de Shockley bidirectionnelle comprenant une couche d'un premier type de conductivité prise en sandwich entre deux couches du deuxième type de conductivité, une première région du premier type de conductivité formée à partir de la face supérieure du substrat dans la couche du deuxième type de conductivité et s'étendant sur sensiblement la moitié de la surface de cette face supérieure, et une deuxième région du premier type de conductivité formée à partir de la face inférieure du substrat dans la couche du deuxième type de conductivité et s'étendant sensiblement sur une moitié complémentaire de la surface de cette face inférieure. Chacune des première et deuxième régions déborde par rapport au plan médian du composant d'une longueur r telle que r/e soit compris entre 0,1 et 0,3, e étant l'épaisseur du composant.

Selon un mode de réalisation de la présente invention, r/e est voisin de 0,2.

Selon un mode de réalisation de la présente invention, le premier type de conductivité est le type N.

Selon un mode de réalisation de la présente invention, le composant est de type mésa.

Selon un mode de réalisation de la présente invention, le composant est de type planar.

Un avantage important de la présente invention est qu'elle permet d'augmenter le courant maximum supportable par un dispositif de protection du type diode de Shockley bidirectionnelle de dimensions données sans modifier les caractéristiques de fabrication de ce composant mais en ayant seulement recours à une modification de forme du masque de diffusion d'émetteur.

Ces objets, caractéristiques et avantages de la présente invention seront exposés en détail dans la description suivante de modes de réalisation particuliers faite en relation avec les figures jointes parmi lesquelles :
la figure 1 est une vue en coupe d'une diode de Shockley bidirectionnelle de type mésa selon l'art antérieur ;
la figure 2 est une vue en coupe d'une diode de Shockley bidirectionnelle de type mésa selon la présente invention ;
la figure 3 est une courbe illustrant des avantages obtenus par la présente invention ;
la figure 4 est une vue en coupe représentant une variante de diode de Shockley bidirectionnelle de type mésa selon la présente invention ;
la figure 5A est une vue en coupe représentant une variante de diode de Shockley bidirectionnelle de type planar selon la présente invention ;
la figure 5B est une vue de dessus schématique correspondant à la figure 5A ; et
la figure 6 est une vue de dessus, à l'échelle, d'une diode selon la présente invention dans le mode de réalisation de la figure 2 qui en constitue une vue en coupe selon la ligne II-II.

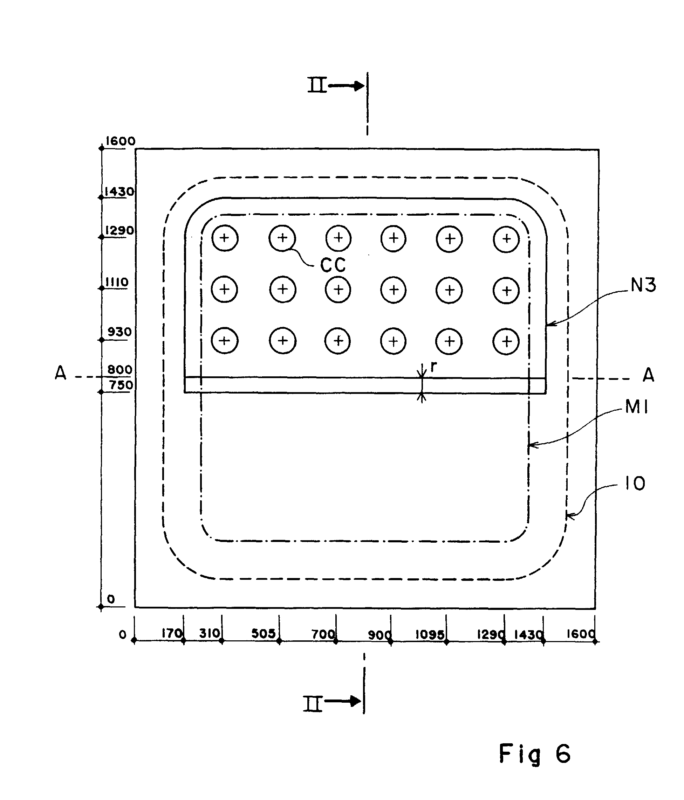

Comme cela est classique dans le domaine de la représentation des semiconducteurs, les diverses figures représentant des vues en coupe et des vues de dessus de composants (sauf la figure 6) sont fortement schématiques et non à l'échelle. En outre, les limites des régions diffusées sont représentées schématiquement sans tenir compte des contours arrondis provoqués par les étapes de diffusion.

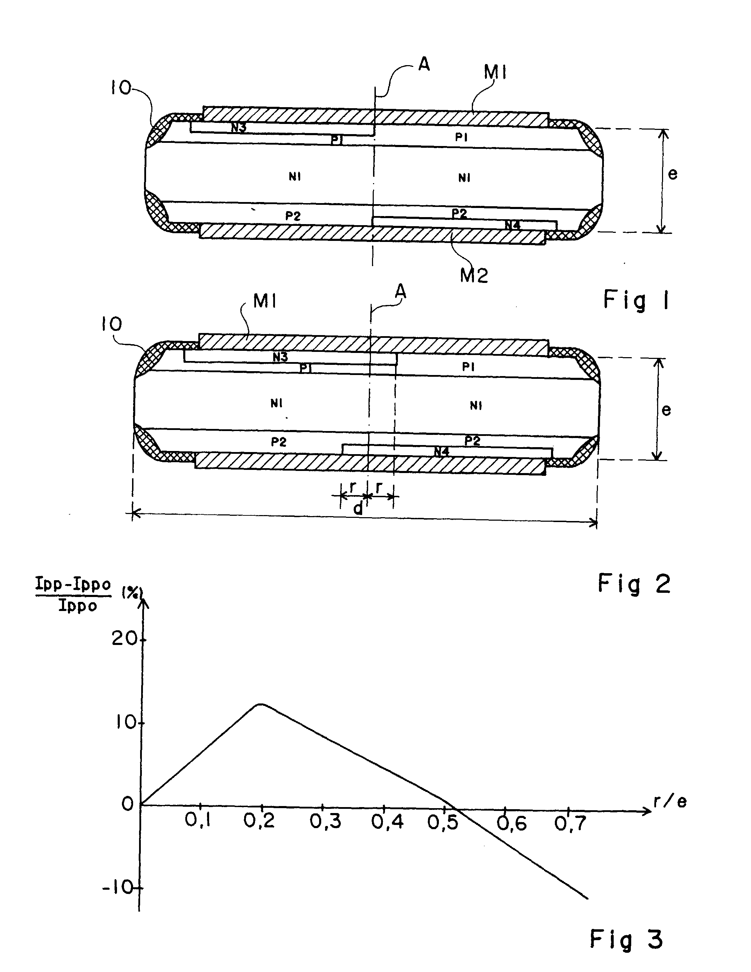

La figure 1 représente schématiquement une vue en coupe d'une diode de Shockley bidirectionnelle classique. Cette diode comprend un substrat N1 de type N dans les faces supérieure et inférieure duquel sont formées des couches diffusées de type P, respectivement P1 et P2. Dans chacune des couches P1 et P2 sont formées, respectivement à partir de la face supérieure et de la face inférieure du composant des régions de type N, respectivement N3 et N4, couramment appelées régions d'émetteur. Classiquement, comme cela est représenté sur la figure 1, chacune des régions N3 et N4 occupe sensiblement la moitié de la surface du composant et ces deux régions ne débordent pas l'une par rapport à l'autre, c'est-à-dire qu'elles sont disposées symétriquement par rapport à un plan médian A. Les surfaces supérieure et inférieure du composant sont respectivement revêtues de métallisations M1 et M2. Dans la structure représentée en figure 1, le composant est de type mésa, c'est-à-dire que sa périphérie est sillonnée et recouverte d'une couche de passivation 10, couramment une glassivation. Généralement, cette couche 10 s'étend partiellement sur la surface supérieure du composant jusqu'à la périphérie des régions N3 et N4. Ainsi, les métallisations M1 et M2 ne sont généralement pas en contact avec les surfaces des régions P1 et P2 s'étendant dans la portion périphérique des régions N3 et N4.

On obtient ainsi de part et d'autre du plan médian A une première diode de Shockley unidirectionnelle constituée des régions N3, P1, N1 et P2 et une deuxième diode de Shockley unidirectionnelle constituée des régions P1, N1, P2 et N4, ces diodes de Shockley étant parfaitement identiques et servant respectivement à absorber des surtensions négative et positive entre les métallisations M1 et M2.

Comme on l'a indiqué précédemment, l'une des caractéristiques importantes d'un composant de protection réside dans le courant maximal IPP qu'il peut laisser passer.

Pour augmenter ce courant, la présente invention prévoit de modifier la structure de la figure 1 de la façon indiquée en figure 2.

La figure 2 représente une structure strictement identique à celle de la figure 1 à l'exception du fait que les régions N3 et N4 présentent une certaine surfaoe en recouvrement. Chacune des régions N3 et N4 s'étend au-delà du plan médian A d'une distance r, c'est-à-dire que, en projection, ces régions présentent une longueur de recouvrement de 2r. Etant donné que les niveaux de dopage et les autres caractéristiques fonctionnelles du composant sont restés inchangés, les paramètres fondamentaux de tension de claquage sont inchangés. Toutefois, la demanderesse a constaté que la prévision de ce recouvrement partiel des couches N3 et N4 entraîne un accroissement de la valeur du courant de crête IPP supportable par le composant.

Cette caractéristique est illustrée en figure 3 dans laquelle les abscisses correspondent au rapport r/e, e étant l'épaisseur du composant (à strictement parler l'épaisseur de ce composant réduite de l'épaisseur d'une couche N3 ou N4). Les ordonnées indiquent la variation en pourcent du courant IPP par rapport au courant IPP₀ d'un système classique tel que celui de la figure 1 dans lequel il n'y a pas de recouvrement entre les régions N3 et N4. On s'aperçoit que, dans un premier temps, quand le rapport r/e augmente, le courant IPP augmente également et l'on obtient une augmentation qui dépasse 10 % pour un rapport r/e sensiblement égal à 0,2. Ensuite, la valeur IPP décroît tout en restant supérieure à IPP₀ jusqu'à une valeur du rapport r/e sensiblement égale à 0,5. Si l'on augmente alors davantage le recouvrement, le courant IPP devient inférieur au courant IPP₀, c'est-à-dire que l'augmentation du recouvrement devient néfaste.

En pratique, les épaisseurs des diodes de Shockley sont de l'ordre de 0,2 à 0,35 mm (200 à 350 µm), c'est-à-dire que, pour un rapport r/e de 0,2, r est égal à 40 à 70 µm. Dans les technologies couramment utilisées pour la fabrication des composants semiconducteurs, ces valeurs sont loin d'être négligeables puisque les divers masquages sont généralement réalisés avec une précision de l'ordre de 1 à 3 µm.

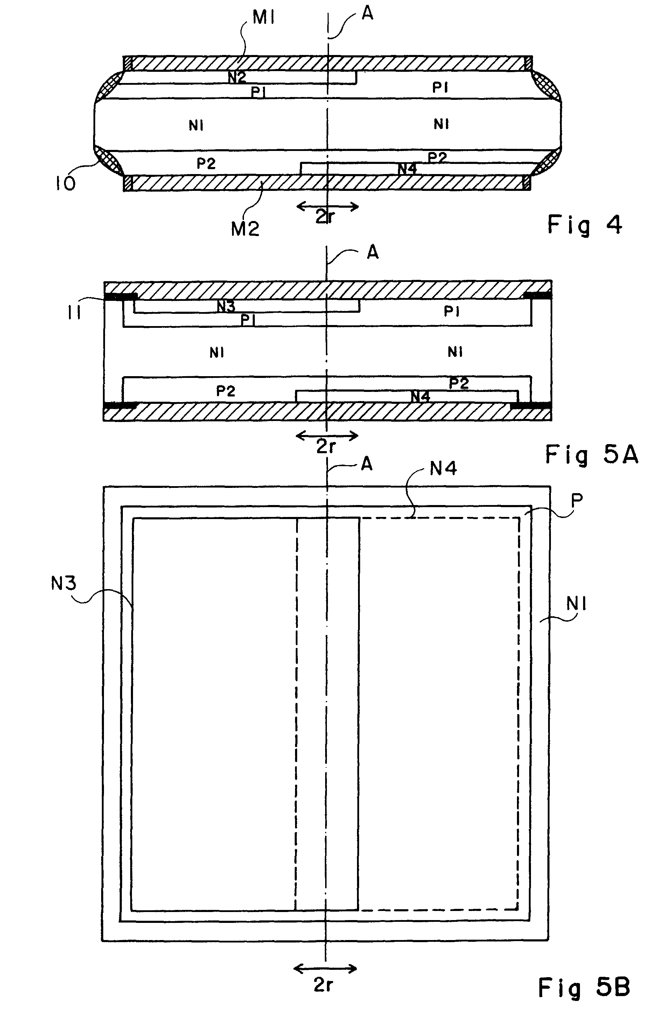

La figure 4 représente une première variante de réalisation de la présente invention. Dans cette figure, les régions N3 et N4 s'étendent jusqu'à la périphérie du composant qui est comme précédemment un composant de type mésa. On a également représenté dans cette figure le cas où les métallisations M1 et M2 s'étendent jusqu'à la périphérie du composant. Dans ce cas, la mise en oeuvre de l'invention procure des avantages similaires à ceux exposés ci-dessus.

La figure 5A représente une variante de réalisation de type planar d'une double diode de Shockley selon la présente invention. Dans ce cas, des régions P1 et P2 au lieu d'être des couches s'étendant sur toute la surface supérieure et inférieure du composant sont des caissons limités latéralement et la région N1 remonte périphériquement jusqu'aux surfaces inférieure et supérieure du composant. Les régions N3 et N4 sont formées comme précédemment dans chacune des régions P1 et P2. Dans ce mode de réalisation, les surfaces apparentes des jonctions sont revêtues d'une couche de passivation 11, couramment de l'oxyde de silicium. Dans ce cas aussi, la mise en oeuvre de l'invention procure des avantages similaires à ceux exposés ci-dessus.

La figure 5B représente une vue de dessus correspondant à la vue en coupe de la figure 5A. On peut y voir à la périphérie la région N1 dans laquelle est formé le caisson P1. On a représenté par un contour en traits pleins les limites de la région N3 et par un contour en pointillés les limites de la région N4. On peut ainsi clairement voir le recouvrement 2r entre ces couches.

Des essais pratiques de la présente invention ont été faits en particulier en utilisant une structure du type de celle de la figure 2 dont une vue de dessus cotée est illustrée en figure 6. Dans cette figure, la référence 10 indique les limites du sillon (d'une largeur d'environ 100 µm), la référence M1 la limite de la métallisation supérieure qui déborde par rapport au plan médian A de sensiblement 50 µm, et la référence N3 le contour de la région d'émetteur. On notera que la région N3 est interrompue aux niveaux d'emplacements CC qui constituent de façon classique des courts-circuits d'émetteur (ici 18 trous d'un diamètre de 90 µm).

Les composants présentaient des caractéristiques choisies dans les plages suivantes :

| | |
|---|---|
| épaisseur | 270 µm |
| dimension | 1,6x1,6 mm² |
| dopage de la couche N1 | 1,5.10¹⁵ à 10¹⁷ at./cm³ |
| dopage des couches P1 et P2 | Cₛ ≃ 5.10¹⁷ à 5.10¹⁸ at./cm³ |
| profondeur de jonction | xp ≃ 25 à 45 µm |
| dopage des couches N3 et N4 | cₛ ≃ 10¹⁹ at./cm³ |
| profondeur de jonction | xp ≃ 15 à 25 µm |
| tension de claquage | 60 à 320 V |
| (Cₛ étant le dopage en surface). | |

Avec un composant classique, similaire à celui des figures 2 et 6 mais où r=0, on a observé une valeur de IPP₀=67 A et pour un composant du type de celui de la figure 6 dans lequel r/e est sensiblement égal à 0,2, on a obtenu IPP=75 A.

On notera que, dans cet exemple, le débordement r par rapport au plan médian (50 µm) correspond à moins de 10 % de la largeur de la région N3 jusqu'au plan médian (0,65 mm).

Par ailleurs, la présente invention s'applique de même à une structure où tous les types de conductivité seraient intervertis, c'est-à-dire que la structure serait construite à partir d'un substrat de type P.

## Revendications

1. Composant de protection du type diode de Shockley bidirectionnelle comprenant une couche (N1) d'un premier type de conductivité prise en sandwich entre deux couches (P1, P2) du deuxième type de conductivité, une première région (N3) du premier type de conductivité formée à partir de la face supérieure du substrat dans la couche (P1) du deuxième type de conductivité et s'étendant sur sensiblement la moitié de la surface de cette face supérieure, et une deuxième région (N4) du premier type de conductivité formée à partir de la face inférieure du substrat dans la couche (P2) du deuxième type de conductivité et s'étendant sensiblement sur une moitié complémentaire de la surface de cette face inférieure,
caractérisé en ce que chacune des première et deuxième régions déborde par rapport au plan médian du composant d'une longueur r telle que r/e soit compris entre 0,1 et 0,3, e étant l'épaisseur du composant, d'où il résulte que la tenue en courant d'un composant de surface donnée est augmentée.

2. Composant de protection selon la revendication 1, caractérisé en ce que r/e est voisin de 0,2.

3. Composant de protection selon la revendication 1, caractérisé en ce que le premier type de conductivité est le type N.

4. Composant de protection selon la revendication 1, caractérisé en ce qu'il est de type mésa.

5. Composant de protection selon la revendication 1, caractérisé en ce qu'il est de type planar.

## Claims

1. A protection component of the bidirectional Shockley diode-type including a layer (N1) of a first conductivity type sandwiched between two layers (P1, P2) of the second conductivity type; a first region (N3) of the first conductivity type formed from the upper surface of the substrate in the layer (P1) of the second conductivity type and extending over substantially one half of said upper surface; and a second region (N4) of the first conductivity type formed from the lower surface of the substrate in the layer (P2) of the second conductivity type and extending substantially over one complementary half of the surface of said lower surface,
characterized in that each first and second region protrudes with respect to the median plane of the component by a length r such that ratio r/e is between 0.1 and 0.3, e being the thickness of the component, whereby the current flowing through a component having a predetermined surface area is increased.

2. The protection component of claim 1, characterized in that ratio r/e is close to 0.2.

3. The protection component of claim 1, characterized in that the first conductivity type is N-type.

4. The protection component of claim 1, characterized in that the component is of the mesa-type.

5. The protection component of claim 1, characterized in that the component is of the planar-type.

## Patentansprüche

1. Schutzbauteil vom bidirektionalen Shockleydiodentyp, umfassend eine sandwichartig zwischen zwei Schichten (P1,P2) eines zweiten Leitfähigkeitstyps angeordnete Schicht (N1) eines ersten Leitfähigkeitstyps, einen ersten Bereich (N3) des ersten Leitfähigkeitstyps, der von der Oberseite des Substrats aus in der Schicht (P1) vom zweiten Leitfähigkeitstyp ausgebildet ist und sich im wesentlichen über die Hälfte der Fläche dieser Oberseite erstreckt, und einen zweiten Bereich (N4) vom ersten Leitfähigkeitstyp, der von der Unterseite des Substrats her in der Schicht (P2) vom zweiten Leitfähigkeitstyp ausgebildet ist und sich im wesentlichen über eine komplementäre Hälfte der Fläche dieser Unterseite erstreckt,
**dadurch gekennzeichnet**, daß
jeweils jeder erste und zweite Bereich bezüglich der Medianebene des Bauteils um eine solche Strecke r übersteht, daß das Verhältnis r/e, worin e die Dicke des Bauteils bedeutet, im Bereich zwischen 0,1 und 0,3 liegt, derart daß sich ein erhöhtes Stromführungsvermögen eines Bauteils gegebener Oberfläche ergibt.

2. Schutzbauteil nach Anspruch 1, dadurch gekennzeichnet, daß das Verhältnis r/e einen Wert um 0,2 besitzt.

3. Schutzbauteil nach Anspruch 1, dadurch gekennzeichnet, daß der erste Leitfähigkeitstyp N-Leitfähigkeit ist.

4. Schutzbauteil nach Anspruch 1, dadurch gekennzeichnet, daß es vom Mesa-Typ ist.

5. Schutzbauteil nach Anspruch 1, dadurch gekennzeichnet, daß es vom Planartyp ist.
